# FASCICULE DE BREVET EUROPEEN

(11) **EP 3 428 956 B1**
(45) Date de publication et mention de la délivrance du brevet: **06.04.2022**
(21) Numéro de dépôt: 18182597.7
(22) Date de dépôt: 10.07.2018
(51) Int. Cl.: H01L 21/02, B81C 1/00, G03F 7/00

(54) **PROCÉDÉ DE FABRICATION D'UN MICRO/NANO-FILTRE SUR UN MICRO/NANO-CANAL OU MICRO/NANO-CAVITÉ RÉALISÉ DANS UN SUBSTRAT SILICIUM**
HERSTELLUNGSVERFAHREN EINES MIKRO/NANO-FILTERS AUF EINEM MIKRO/NANO-KANAL ODER EINEM MIKRO/NANO-HOHLRAUM IN EINEM SILIZIUMSUBSTRAT
METHOD FOR MANUFACTURING A MICRO/NANO-FILTER ON A MICRO/NANO-CHANNEL OR MICRO/NANO-CAVITY MADE IN A SILICON SUBSTRATE

(30) Priorité: 11.07.2017 FR 1756564
(43) Date de publication de la demande: 16.01.2019
(73) Titulaire: Commissariat à l'Énergie Atomique et aux Énergies Alternatives, 75015 Paris (FR)
(72) Inventeur: NOURI, Lamia, 38100 GRENOBLE (FR); GAILLARD, Frédéric-Xavier, 38500 VOIRON (FR); LANDIS, Stefan, 38210 TULLINS (FR); POSSEME, Nicolas, 38360 SASSENAGE (FR)
(74) Mandataire: INNOV-GROUP

(56) Documents cités:
- FR-A1- 2 874 909
- FR-A1- 2 897 198
- US-A1- 2011 002 359
- US-A1- 2012 049 200
- US-A1- 2017 097 270
- METZ S ET AL: "Polyimide microfluidic devices with integrated nanoporous filtration areas manufactured by micromachining and ion track technology", JOURNAL OF MICROMECHANICS AND MICROENGINEERING, vol. 14, no. 3, mars 2004 (2004-03), pages 324-331, XP002780289, IOP PUBLISHING UK ISSN: 0960-1317
- CRUZ S ET AL: "Fabrication and optimization of porous silicon substrates for diffusion membrane applications", JOURNAL OF THE ELECTROCHEMICAL SOCIETY ELECTROCHEM. SOC. USA, vol. 152, no. 6, juin 2005 (2005-06), pages C418-C424, XP002780291, ISSN: 0013-4651
- ZHANG S ET AL: "Microfabricated silicon nitride membranes for hepatocyte sandwich culture", BIOMATERIALS, vol. 29, no. 29, octobre 2008 (2008-10), pages 3993-4002, XP002780290, ELSEVIER SCIENCE LTD. UK ISSN: 0142-9612
- SPLINTER A ET AL: "Micro membrane reactor: a flow-through membrane for gas pre-combustion", SENSORS AND ACTUATORS B, vol. 83, 15 mars 2002 (2002-03-15), pages 169-174, XP004344501, ISSN: 0925-4005
- TANTAWI K H ET AL: "Porous silicon membrane for investigation of transmembrane proteins", SUPERLATTICES AND MICROSTRUCTURES, vol. 58, juin 2013 (2013-06), pages 72-80, XP002780293, ACADEMIC PRESS INC. USA ISSN: 0749-6036

## Description

### Domaine technique de l'invention

La présente invention se rapporte à un procédé de fabrication d'un micro/nano-filtre sur un micro/nano-canal ou micro/nano-cavité réalisé dans un substrat silicium. L'invention concerne également la structure micro/nano-fluidique obtenue à l'issue du procédé.

### Etat de la technique

Dans le domaine de la micro-fluidique ou même nano-fluidique, il est connu de réaliser des architectures fluidiques dans des puces en silicium, formant ce qui est appelé des laboratoires sur puce ("Lab on chip").

Il s'agit de réaliser un ou plusieurs canaux et/ou une ou plusieurs cavités dans un substrat en silicium, dont au moins une dimension est inférieure à 100µm pour la micro-fluidique ou inférieure à 100nm pour la nano-fluidique.

Pour différentes applications, il est notamment utile de proposer une fonction de filtration au sein de l'architecture micro-fluidique ou nano-fluidique, c'est-à-dire une fonction dans laquelle le fluide injecté dans la puce est filtré pour séparer certains de ses composants, selon la taille des pores de filtration.

Les publications listées ci-dessous font déjà état de solutions pour réaliser une membrane de filtration poreuse dans un dispositif micro-fluidique :
- *"*Polyimide Microfludic Devices with Integrated Nanoporous Filtration Areas Manufactured by Micomachining an Ion Track Technology" - Metz *et al.*
- *"*Microfabricated Silicon Nitride Membranes for Hepatocyte Sandwich Culture" - Zhang *et al.*
- *"*Fabrication and Optimization of Pourous Silicon Substrates for Diffusion Membrane Applications" - Cruz, Hönig-d'Orville, Müller
- *"*Micro Membrane reactor" - Splinter *et al.*
- *"*Porous Silicon Membrane for Investigation of Transmembrane Proteins"-Tantawi *et al.*

Cependant, ces solutions ne sont pas forcément satisfaisantes et pas toujours adaptées pour des architectures de type nano-fluidiques.

Le but de l'invention est donc de proposer un procédé de réalisation d'un micro/nano-filtre applicable dans une architecture de type micro-fluidique ou nano-fluidique.

### Exposé de l'invention

Ce but est atteint par un procédé de fabrication d'un micro/nano-filtre sur un micro/nano-canal ou micro/nano-cavité présents dans une couche de silicium, ledit procédé comprenant les étapes suivantes :
- Une étape de lithographie, pour générer une couche de résine sur ladite couche de silicium de manière à former une structure en résine sur la couche de silicium, ladite structure comportant au moins une zone cible ;
- Une étape de réalisation d'une couche carbonée en surface de ladite couche de silicium au niveau de ladite zone cible ;
- Une étape de création de zones implantées par implantation ionique à travers ladite structure formée par ladite couche de résine au niveau de ladite zone cible ;
- Une étape de retrait de la couche de résine et de maintien au moins en partie de la couche carbonée sur ladite zone cible ;
- Une étape de porosification du silicium et de la couche carbonée au niveau de ladite zone cible afin d'obtenir une zone cible porosifiée ;
- Une étape de nettoyage de ladite zone cible porosifiée pour retirer le silicium poreux de ladite zone cible et former au moins une cavité fermée en surface par une membrane poreuse carbonée.

Selon une réalisation particulière, ladite étape de réalisation d'une couche carbonée est mise en œuvre lors de l'étape de création des zones implantées par dégradation de ladite couche de résine, par une implantation ionique d'ions lourds.

Selon une réalisation particulière, ladite étape de réalisation d'une couche carbonée comporte une étape de dépôt d'une couche carbonée sur la couche de silicium, réalisée préalablement à ladite étape de lithographie.

Selon une réalisation particulière, la couche carbonée est une couche de type BARC ("Bottom Anti-reflective coating").

Selon une réalisation particulière, ladite étape de création de zones implantées est mise en œuvre par implantation ionique en employant des ions lourds.

Selon une réalisation particulière, les ions lourds employés sont des ions d'atome de masse volumique plus élevée que celle du Bore.

Selon une réalisation particulière, l'étape de réalisation d'une couche carbonée comporte une étape d'implantation ionique d'ions carbone à travers la structure formée par ladite couche de résine et cette étape est mise en œuvre entre l'étape de lithographie et ladite étape de création de zones implantées.

Selon une réalisation particulière, l'étape de nettoyage est réalisée dans une solution de gravure humide du silicium, choisie parmi une gravure à base de KOH (potasse) ou une gravure à base de TMAH (Tetramethylammonium hydroxide).

Selon une réalisation particulière, l'étape de lithographie est mise en œuvre selon une technologie choisie parmi une technologie de type optique, une technologie de type électronique, une technologie par nano-impression et une technologie par auto-assemblage de co-polymère à bloc.

L'invention concerne également une structure micro/nano-fluidique comprenant une couche de silicium, cette structure comportant au moins une membrane poreuse dans la couche de silicium formant un micro/nano-filtre réalisé à l'aide du procédé tel que défini ci-dessus.

Contrairement aux documents antérieurs précités, la structure obtenue présente une membrane poreuse carbonée dans une couche de silicium.

### Brève description des figures

D'autres caractéristiques et avantages vont apparaître dans la description détaillée qui suit faite en regard des dessins annexés dans lesquels :
- La figure 1 représente une première variante de réalisation du procédé de l'invention.
- La figure 2 représente une deuxième variante de réalisation du procédé de l'invention.
- La figure 3 représente une troisième variante de réalisation du procédé de l'invention.
- La figure 4 montre, en vue de dessus, une image obtenue par microscopie électronique à balayage d'une structure micro/nano fluidique comprenant plusieurs membranes poreuses obtenues grâce au procédé de l'invention.
- La figure 5 représente, en vue en coupe, une image obtenue par microscopie électronique à balayage d'une structure micro/nano fluidique comprenant plusieurs membranes poreuses obtenues grâce au procédé de l'invention.

### Description détaillée d'au moins un mode de réalisation

Dans l'ensemble du texte de la demande, nous ferons référence à l'aspect "micro" ou "nano" de l'application du procédé de l'invention. Celui-ci peut en effet s'adapter de la même manière à la réalisation d'architectures de type micro-fluidique comprenant un élément fluidique ayant au moins une dimension qui est inférieure à 100µm ou à des architectures de type nano-fluidique comprenant un élément fluidique ayant au moins une dimension qui est inférieure à 100nm.

Par élément fluidique, on entend un canal, une cavité ou réservoir ou tout autre élément susceptible de recevoir un fluide et réalisé dans une couche de silicium de manière à former une puce micro/nano-fluidique.

Par fluide, on entend bien entendu un liquide, un gaz, un gel...

Les termes "sur", "sous", "supérieur" ou "inférieur" sont à comprendre en prenant comme référence un axe vertical (X) dessiné sur la surface du papier et allant du bas vers le haut de la feuille de papier.

Dans la suite de la description, par le terme "zone" qui est employé, on entend un volume délimité de la structure de la puce et inférieur à tout le volume de la puce, ce volume comportant trois dimensions, c'est-à-dire une profondeur non nulle suivant l'axe vertical (X) défini ci-dessus, une longueur et une largeur non nulles suivant les deux autres axes perpendiculaires à cet axe vertical.

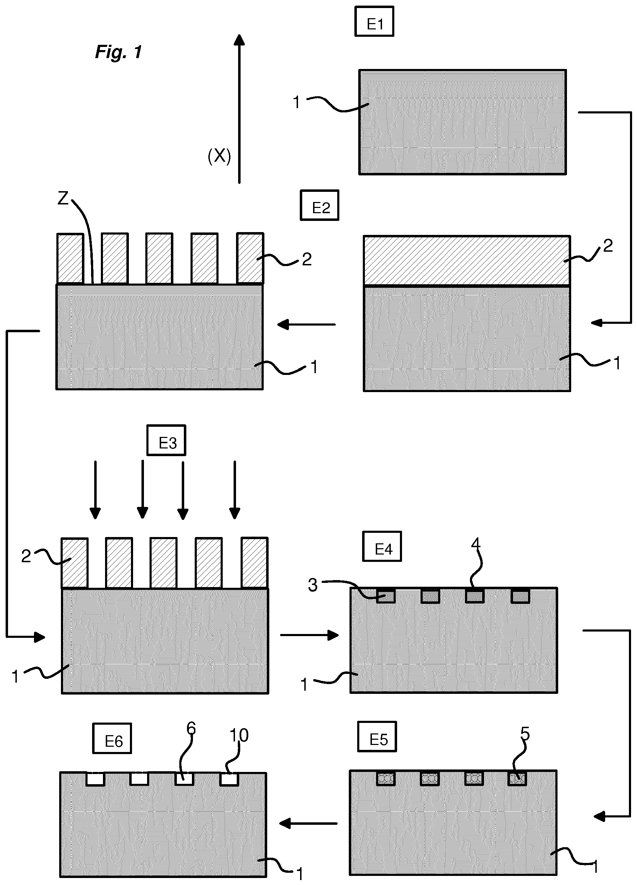

Les figures 1 à 3 illustrent trois variantes de réalisation du procédé de l'invention. Les figures 1 à 3 sont des vues en coupe, permettant de montrer les différentes couches qui interviennent dans la mise en oeuvre du procédé de l'invention.

Pour la réalisation d'un micro/nano-filtre dans une puce micro/nano-fluidique, le procédé de l'invention s'appuie notamment sur quelques étapes fondamentales, décrites ci-dessous.

Le procédé de l'invention est mis en œuvre sur une couche de base. Cette couche de base pourra être formée d'une seule couche de silicium ou d'un ensemble de couches superposées, la couche de silicium 1 étant la couche supérieure. Son épaisseur sera avantageusement comprise entre 1 et plusieurs centaines de nanomètres.

Le nano-filtre obtenu dans la puce micro/nano-fluidique créée à l'issue du procédé de l'invention est formé d'une membrane carbonée 10 présente en surface de la couche de silicium 1, préférentiellement affleurante à la surface supérieure de la couche de silicium 1. Il faut noter que des étapes complémentaires pourront être mises en œuvre pour parvenir à une puce micro/nano-fluidique plus complète, notamment en rajoutant des couches supplémentaires par la suite pour compléter l'architecture de la puce.

Le principe de l'invention consiste à réaliser un apport en carbone sur/dans la couche de silicium. Il s'agira donc de former une couche de silicium contaminée en carbone. Après notamment une étape de porosification localisée, la couche de carbone résiduelle sera amenée à former une membrane poreuse dans la puce micro/nano-fluidique, formant le micro/nano-filtre souhaité. Pour parvenir à cette architecture, d'autres étapes seront mises en œuvre en amont et/ou en aval de cette étape d'apport en carbone. Ces autres étapes sont décrites ci-dessous.

Le procédé de l'invention comporte notamment une étape de lithographie permettant de créer un motif dans une couche de résine 2 de lithographie présente sur la couche de silicium. La couche de résine se compose ainsi d'une couche d'un polymère carboné. De manière non limitative, la résine employée sera par exemple de type CR01P disponible commercialement auprès de la, société Tokyo Ohka Kogyo CO. Ltd ou de type M78Y proposé par la société JSR Electronics NV.

Toutes les techniques de lithographie peuvent être envisagées dans le procédé de l'invention. De manière non exhaustive et non limitative, il pourra s'agir :
- D'une lithographie de type optique ;

En lithographie optique, un film de résine, déposé en surface d'un substrat de silicium, est exposé par un flux de photons à travers un masque. Ce film de résine est donc exposé de manière sélective. Dans les zones exposées, les photons réagissent avec la résine et modifient ses propriétés de solubilité. Les motifs sont ensuite révélés dans du développeur (typiquement une solution aqueuse basique) : les zones de la résine qui sont peu solubles subsistent à la surface du substrat, le reste de la résine étant solubilisé dans le développeur.
- D'une lithographie de type électronique ;

La lithographie électronique est une technique de lithographie sans masque (ou *"Mask Less Lithography"* : ML2) fonctionnant avec un faisceau d'électrons.

Les motifs sont directement dessinés à l'aide de ce faisceau qui balaye le film de résine déposé sur le substrat.
- D'une lithographie par nano-impression ;

La nano-impression est une technique de lithographie émergente qui produit des motifs dans la résine par contraste topographique. En effet, le masque est remplacé par un moule, présentant des motifs tridimensionnels sur sa face active (face en contact avec la résine). Ce moule est pressé dans la résine qui remplit alors ses cavités.
- D'une lithographie par auto-assemblage dirigé (DSA) ;

A l'issue de l'étape de lithographie, la couche de résine 2 déposée présente avantageusement une structure particulière formant une ou plusieurs cavités débouchant sur la surface de la couche de silicium ou d'une couche déposée sur la couche de silicium et permettant chacune de délimiter une zone (Z) cible dans la couche de silicium destinée à la réalisation d'un micro/nano-filtre selon le procédé de l'invention.

Le procédé comporte également une étape de création de zones implantées, destinée à implanter des ions dans la couche de silicium au niveau de chaque zone Z cible déterminée par la structure de la couche de résine 2. La profondeur de l'implantation dépendra de la profondeur souhaitée de la zone cible Z. Celle-ci sera réglée par les différents paramètres de réglage de l'implantation (énergie fournie, pression surfacique, dose, degré d'inclinaison de l'implantation...).

Le procédé comporte également une étape de porosification sélective permettant notamment de rendre le silicium poreux au niveau des zones cibles Z qui ont été implantées et de créer la membrane poreuse du filtre. Le silicium poreux est obtenu par anodisation du silicium dans un électrolyte, généralement à base d'acide fluorhydrique (HF). Plusieurs paramètres régissent la formation du silicium poreux, notamment le courant appliqué au substrat, la nature de l'électrolyte, le type de substrat et le taux d'illumination. Selon le courant appliqué à l'anode, la dissolution du silicium va suivre soit un régime de porosification, soit un régime d'électro-polissage. Dans la présente invention on s'intéressera au premier régime.

Le procédé comporte également une étape finale de nettoyage de chaque zone cible Z qui a été porosifiée, permettant de retirer le silicium poreux présent dans chaque zone ciblée et d'obtenir définitivement chaque membrane poreuse 10 faisant office de nano-filtre. De manière non limitative, ce nettoyage sera réalisé dans une solution de gravure humide du silicium (gravure sélective selon les plans cristallins) - Gravure KOH (Potasse) - Gravure TMAH (Tetramethylammonium hydroxide), en phase vapeur (en employant de l'Ammoniac par exemple), ou en phase super critique.

De manière plus précise, en référence à la figure 1, selon une première variante de réalisation, le procédé comporte les étapes suivantes :
E1 : Il s'agit de disposer d'une couche de base en silicium 1.
E2 : Il s'agit de mettre en place l'étape de lithographie selon l'une des techniques évoquées ci-dessus afin de disposer une couche de résine 2 sur la couche de silicium 1 et de former un motif dans la couche de résine, formant des cavités dans la résine débouchant directement sur la surface supérieure de la couche de silicium. Ces cavités permettent d'identifier chaque zone cible Z où sera réalisé un micro/nano-filtre selon l'invention.
E3 : Il s'agit de mettre en place l'étape de création de zones implantées telle que décrite ci-dessus afin d'implanter des ions lourds dans la couche de silicium au niveau de chaque zone cible Z. Cette étape d'implantation est donc mise en œuvre à travers la structure formée par la couche de résine 2 sur la couche de silicium 1 et permet de créer des zones implantées 3 dans la couche de silicium au niveau des cavités laissées par la structure de la couche de résine. Lors de l'implantation, les ions lourds viennent dégrader la couche de résine et à l'issue de cette étape, des résidus de carbone issus de la couche de résine 2 permettent de contaminer la couche de silicium et forment une couche carbonée 4 en surface de la couche de silicium 1 au niveau des zones cibles Z. les ions lourds employés dans l'implantation sont des ions dont la masse volumique est plus élevée que celle du Bore, par exemple de type Argon.
E4 : Il s'agit de mettre en place une étape dite de "stripping" permettant le retrait de la couche de résine 2 présente sur la couche de silicium 1. Les résidus de carbone restent présents au niveau des zones implantées et contaminent le silicium en surface.
E5 : Il s'agit de la réalisation de l'étape de porosification localisée telle que décrite ci-dessus. Elle permet de rendre le silicium et la couche carbonée poreux au niveau des zones cibles Z et de former des zones poreuses localisées 5.
E6 : Il s'agit de la mise en œuvre de l'étape de nettoyage telle que décrite ci-dessus. Lors de cette étape, il s'avère que la couche carbonée 4 formée par les résidus de carbone est résistante à cette étape de nettoyage. A l'issue de cette étape de nettoyage, les zones implantées sont désormais creuses et forment des cavités 6 ou canaux. La couche carbonée qui a été porosifiée reste présente ce qui permet de former pour chaque zone cible, une membrane poreuse 10 formant un micro/nano-filtre.

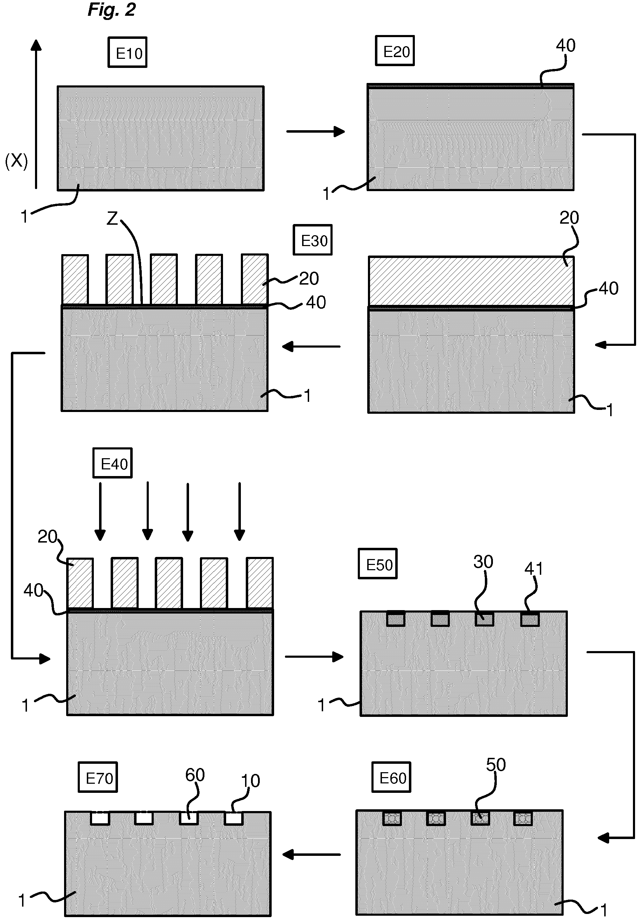

La figure 2 représente une deuxième variante de réalisation du procédé de l'invention. Il comporte les étapes décrites ci-dessous, certaines étant identiques à celles décrites en référence à la figure 1.
E10 : Il s'agit de disposer d'une couche de base en silicium 1.
E20 : Il s'agit de déposer une couche carbonée 40 sur toute la couche de base en silicium 1. De manière non limitative, cette couche carbonée 40 sera par exemple une couche de BARC (pour "Bottom Anti-reflective coating") qui est un revêtement anti-réfléchissant souvent utilisé dans le domaine de la lithographie.
E30 : Il s'agit de mettre en place l'étape de lithographie selon l'une des techniques évoquées ci-dessus afin de disposer une couche de résine 20 sur la couche carbonée et de former un motif dans la couche de résine, formant des cavités dans la résine débouchant directement sur la surface supérieure de la couche carbonée. Ces cavités permettent d'identifier chaque zone cible Z où sera réalisé un micro/nano-filtre selon l'invention.
E40 : Il s'agit de mettre en place l'étape de création des zones implantées telle que décrite ci-dessus afin d'implanter des ions lourds dans la couche de silicium 1 au niveau de chaque zone cible Z. Cette étape d'implantation est donc mise en œuvre à travers la structure formée par la couche de résine 20 et permet de créer des zones implantées dans la couche de silicium 1 au niveau des cavités laissées par la structure de la couche de résine 20. Les zones implantées 30 sont réalisées sous la couche carbonée 40.
E50 : Il s'agit de mettre en place une étape dite de "stripping" permettant le retrait de la couche de résine 20 présente sur la couche carbonée 40 et de la couche carbonée 40 présente sur la couche de silicium 1, en dehors des zones cibles. A l'issue de cette étape, des résidus de carbone 41 restent présents au niveau des zones implantées et contaminent le silicium en surface.
E60 : Il s'agit de la réalisation de l'étape de porosification localisée telle que décrite ci-dessus. Elle permet de rendre le silicium et la couche carbonée poreux au niveau des zones cibles Z et de former des zones poreuses localisées 50.
E70 : Il s'agit de la mise en œuvre de l'étape de nettoyage telle que décrite ci-dessus. Lors de cette étape, il s'avère que la couche carbonée est résistante à cette étape de nettoyage. A l'issue de cette étape de nettoyage, les zones implantées sont désormais creuses et forment des cavités 60 ou canaux. La couche carbonée porosifiée reste présente et permet de générer pour chaque zone cible, une membrane poreuse 10 formant un micro/nano-filtre.

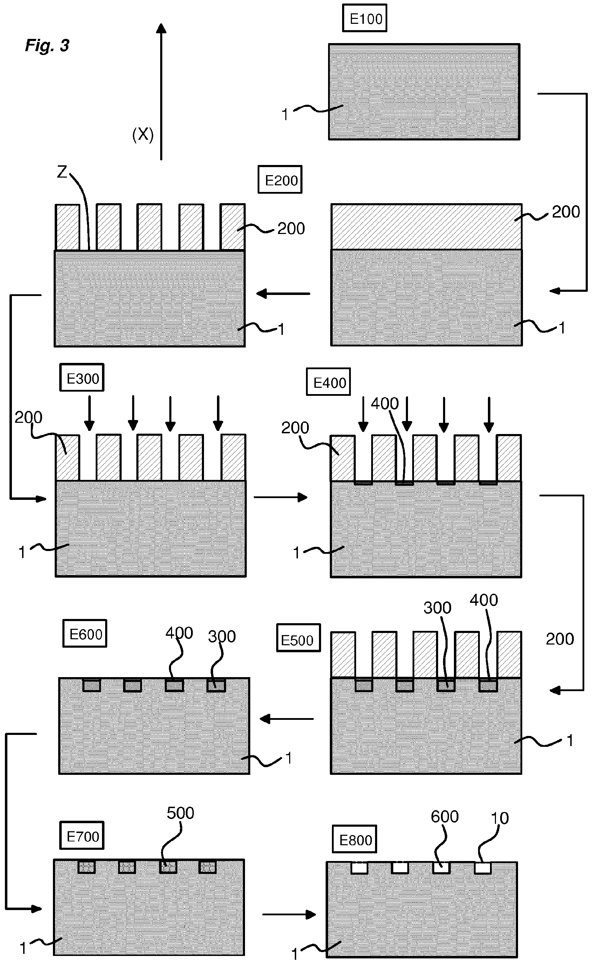

La figure 3 représente une troisième variante de réalisation du procédé de l'invention. Il comporte les étapes décrites ci-dessous, certaines étant identiques à celles décrites en référence aux figures 1 et 2.
E100 : Il s'agit de disposer d'une couche de base en silicium 1.
E200 : Il s'agit de mettre en place l'étape de lithographie selon l'une des techniques évoquées ci-dessus afin de disposer une couche de résine 200 sur la couche de silicium 1 et de former un motif dans la couche de résine 200, formant des cavités dans la résine débouchant directement sur la surface supérieure de la couche de silicium 1. Ces cavités permettent d'identifier chaque zone cible Z où sera réalisé un micro/nano-filtre selon l'invention.
E300 : Il s'agit de réaliser une étape d'implantation ionique pour implanter directement des ions à base de carbone dans la couche de silicium, à travers la structure formée la couche de résine présente sur la couche de silicium afin d'obtenir une couche ou zone carbonée 400 implantée sur/dans la couche de silicium au niveau de chaque zone cible Z. Il est également possible de réaliser une implantation par immersion plasma, dans laquelle tous les composés d'un gaz carboné seront implantés.
E400 : Il s'agit de mettre en place l'étape de création des zones implantées dans la couche de silicium 1. Cette étape pourra être mise en œuvre en employant des ions légers tels que des ions hydrogène ou hélium ou en employant des ions lourds permettant alors un second apport de carbone, par dégradation de la couche de résine 200. Cette étape est mise en œuvre à travers la structure formée par la couche de résine 2 sur la couche de silicium 1 et permet de créer des zones implantées 300 dans la couche de silicium, sous chaque zone déjà implantée 400 en carbone, au niveau des cavités laissées par la structure de la couche de résine. Cette implantation sera donc effectuée plus en profondeur dans la couche de silicium 1 que l'implantation ionique des ions carbone.
E500 : Il s'agit de mettre en place une étape dite de "stripping" permettant le retrait de la couche de résine 200 présente sur la couche de silicium 100. La couche carbonée 400 issue de l'implantation réalisée dans l'étape E300 reste présente en surface de la couche de silicium 1.
E600 : Elle permet de rendre le silicium et la couche carbonée poreux au niveau des zones cibles Z et de former des zones poreuses localisées 500.
E700 : Il s'agit de la mise en œuvre de l'étape de nettoyage telle que décrite ci-dessus. Lors de cette étape, il s'avère que la couche carbonée 400 porosifiée est résistante à cette étape de nettoyage. A l'issue de cette étape de nettoyage, les zones implantées sont désormais creuses et forment des cavités 600 ou canaux. La couche carbonée porosifiée reste présente et la dispersion de ces résidus permet de former pour chaque zone, une membrane poreuse 10 formant un micro/nano-filtre.

### Exemple de réalisation :

- Lithographie avec couche de BARC ;
- Implantation ionique à l'aide d'ions Ar à 100kev à une dose de 1.E15 at/cm² et à un degré d'inclinaison (tilt - angle par rapport à la normale à la surface du substrat) de 0° ;
- Réalisation de l'étape de "stripping" de la couche de résine
- Porosification des zones implantées à une densité de courant de 6.36mA/cm² dans un électrolyte à base de HF35 % à 60% d'illumination d'une lampe d'une puissance de 3500W pendant 18 secondes ;
- Retrait du Silicium poreux par nettoyage au KOH 5% à froid pendant 2 secondes ; Dans un substrat de Silicium de type P de résistivité (1-50 Ohm.cm)

Par ailleurs, nous donnons ci-dessous quelques conditions expérimentales qui peuvent être employées dans la mise en œuvre des différentes variantes de réalisation décrites ci-dessus :
Les conditions d'implantation pour les ions lourds dont la masse est supérieure à celle du bore :
   - Dose implantée supérieure à 5.10¹⁷ atomes/cm³ ;
   - La profondeur des canaux dépendra de l'énergie d'implantation ;
Les conditions d'implantation pour les ions légers comme l'hydrogène dans le cas de la troisième variante de réalisation (figure 3):
   - Dose supérieure à 1.10¹⁸ atomes/cm³ ;
   - La profondeur des canaux dépendra de l'énergie de d'implantation ;
Les conditions d'implantation pour les ions de carbone dans le cas de la 3ème variante de réalisation (figure 3) :
   - Dose supérieure à 1.10¹⁸ atomes/cm³ ;

Quelle que soit la méthode employée, on comprend que la réalisation d'un micro/nano-filtre est simple à mettre en œuvre. Elle est mise en œuvre essentiellement à l'aide de techniques connues dans le domaine de la micro-électronique notamment. Elle est facilement configurable pour obtenir des micro/nano-filtres dans une puce micro/nano-fluidique dans les zones souhaitées.

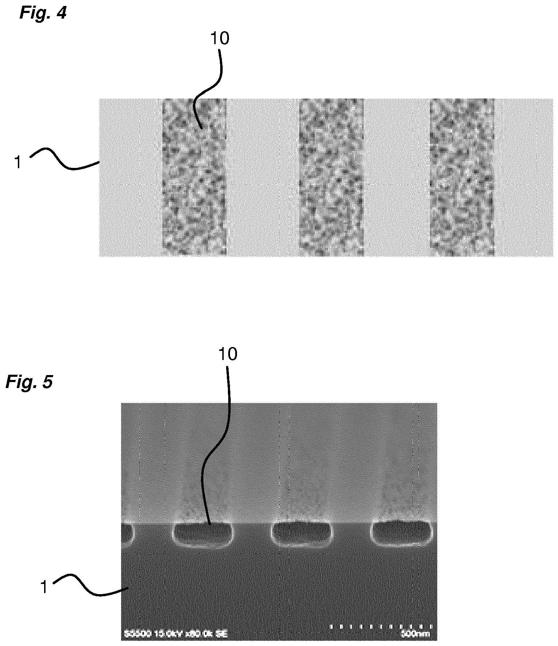

Les figures 4 et 5 représentent, respectivement de manière schématique et en réalité à travers un microscope, une structure micro/nano fluidique obtenue présentant plusieurs membranes poreuses 10.

## Revendications

1. Procédé de fabrication d'un micro/nano-filtre sur un micro/nano-canal ou micro/nano-cavité présents dans une couche de silicium, le procédé comprenant les étapes suivantes :
- Une étape de lithographie (E2, E30, E200), pour générer une couche de résine (2, 20, 200) sur ladite couche de silicium (1) de manière à former une structure en résine sur la couche de silicium, ladite structure comportant au moins une zone cible (Z) ;
- Une étape de réalisation d'une couche carbonée (4, 40, 400) en surface de ladite couche de silicium (1) au niveau de ladite zone cible ;
- Une étape de création (E3, E40, E400) de zones implantées par implantation ionique à travers ladite structure formée par ladite couche de résine (2, 20, 200) au niveau de ladite zone cible ;
- Une étape de retrait (E4, E50, E600) de la couche de résine (2) et de maintien au moins en partie de la couche carbonée (4, 40, 400) sur ladite zone cible ;
- Une étape de porosification (E5, E60, E700) du silicium et de la couche carbonée au niveau de ladite zone cible afin d'obtenir une zone cible porosifiée (5, 50, 500) ;
- Une étape de nettoyage (E6, E70, E800) de ladite zone cible porosifiée pour retirer le silicium poreux de ladite zone cible et former au moins une cavité (6, 60, 600) fermée en surface par une membrane poreuse (10) carbonée.

2. Procédé selon la revendication 1, dans lequel ladite étape de réalisation d'une couche carbonée est mise en œuvre lors de l'étape de création (E3) des zones implantées par dégradation de ladite couche de résine (200), par une implantation ionique d'ions lourds.

3. Procédé selon la revendication 1, dans lequel ladite étape de réalisation d'une couche carbonée comporte une étape de dépôt (E20) d'une couche carbonée (40) sur la couche de silicium (1), réalisée préalablement à ladite étape de lithographie.

4. Procédé selon la revendication 3, dans lequel la couche carbonée (40) est une couche de type BARC ("Bottom Anti-reflective coating").

5. Procédé selon la revendication 3 ou 4, dans lequel ladite étape de création de zones implantées est mise en œuvre par implantation ionique en employant des ions lourds.

6. Procédé selon la revendication 2 ou 5, dans lequel les ions lourds employés sont des ions d'atome de masse volumique plus élevée que celle du Bore.

7. Procédé selon la revendication 1, dans lequel l'étape de réalisation d'une couche carbonée comporte une étape d'implantation ionique (E300) d'ions carbone à travers la structure formée par ladite couche de résine (2) et en ce que cette étape est mise en œuvre entre l'étape de lithographie (E200) et ladite étape de création de zones implantées (E400).

8. Procédé selon l'une des revendications 1 à 7, dans lequel l'étape de nettoyage (E6, E70, E800) est réalisée dans une solution de gravure humide du silicium, choisie parmi une gravure à base de KOH (potasse) ou une gravure à base de TMAH (Tetramethylammonium hydroxide).

9. Procédé selon l'une des revendications 1 à 8, dans lequel l'étape de lithographie (E2, E30, E200) est mise en œuvre selon une technologie choisie parmi une technologie de type optique, une technologie de type électronique, une technologie par nano-impression et une technologie par auto-assemblage de co-polymère à bloc.

10. Structure micro/nano-fluidique comprenant une couche de silicium, la structure comportant au moins une membrane poreuse (10) dans la couche de silicium (1) formant un micro/nano-filtre réalisé à l'aide du procédé tel que défini dans l'une des revendications précédentes.

## Patentansprüche

1. Verfahren zur Herstellung eines Mikro-/Nanofilters auf einem Mikro-/Nanokanal oder Mikro-/Nanohohlraum, die in einer Siliciumschicht vorhanden sind, wobei das Verfahren die folgenden Schritte umfasst:
- Einen Lithografieschritt (E2, E30, E200), um eine Harzschicht (2, 20, 200) auf der Siliciumschicht (1) zu erzeugen, so dass eine Struktur aus Harz auf der Siliciumschicht gebildet wird, wobei die Struktur mindestens einen Zielbereich (Z) beinhaltet;
- Einen Schritt des Ausführens einer kohlenstoffhaltigen Schicht (4, 40, 400) an der Oberfläche der Siliciumschicht (1) auf Höhe des Zielbereichs;
- Einen Schritt des Erzeugens (E3, E40, E400) von implantierten Bereichen durch Ionenimplantation durch die durch die Harzschicht (2, 20, 200) gebildete Struktur hindurch auf Höhe des Zielbereichs;
- Einen Schritt des Entfernens (E4, E50, E600) der Harzschicht (2) und des zumindest teilweisen Aufrechterhaltens der kohlenstoffhaltigen Schicht (4, 40, 400) auf dem Zielbereich;
- Einen Schritt des Porösizierens (E5, E60, E700) des Siliciums und der kohlenstoffhaltigen Schicht auf Höhe des Zielbereichs, um einen porösizierten Zielbereich (5, 50, 500) zu erhalten;
- Einen Schritt des Reinigens (E6, E70, E800) des porösizierten Zielbereichs, um das poröse Silicium von dem Zielbereich zu entfernen und mindestens einen Hohlraum (6, 60, 600) zu bilden, der an der Oberfläche durch eine kohlenstoffhaltige poröse Membran (10) geschlossen wird.

2. Verfahren nach Anspruch 1, bei dem der Schritt des Ausführens einer kohlenstoffhaltigen Schicht bei dem Schritt des Erzeugens (E3) der implantierten Bereiche durch Abbauen der Harzschicht (200) durchgeführt wird, durch eine Ionenimplantation von schweren Ionen.

3. Verfahren nach Anspruch 1, bei dem der Schritt des Ausführens einer kohlenstoffhaltigen Schicht einen Schritt des Aufbringens (E20) einer kohlenstoffhaltigen Schicht (40) auf die Siliciumschicht (1) beinhaltet, der vor dem Lithografieschritt ausgeführt wird.

4. Verfahren nach Anspruch 3, bei dem die kohlenstoffhaltige Schicht (40) eine Schicht vom Typ BARC ("Bottom Anti-Reflective Coating") ist.

5. Verfahren nach Anspruch 3 oder 4, bei dem der Schritt des Erzeugens von implantierten Bereichen durch Ionenimplantation unter Verwendung von schweren Ionen durchgeführt wird.

6. Verfahren nach Anspruch 2 oder 5, bei dem die verwendeten schweren Ionen Ionen eines Atoms mit einer höheren Dichte als der von Bor sind.

7. Verfahren nach Anspruch 1, bei dem der Schritt des Ausführens einer kohlenstoffhaltigen Schicht einen Schritt der Ionenimplantation (E300) von Kohlenstoffionen durch die durch die Harzschicht (2) gebildete Struktur hindurch beinhaltet und dadurch, dass dieser Schritt zwischen dem Lithografieschritt (E200) und dem Schritt des Erzeugens von implantierten Bereichen (E400) durchgeführt wird.

8. Verfahren nach einem der Ansprüche 1 bis 7, bei dem der Schritt des Reinigens (E6, E70, E800) in einer Lösung zum Nassätzen des Siliciums ausgeführt wird, das unter einem Ätzen auf der Basis von KOH (Kalium) oder einem Ätzen auf der Basis von TMAH (Tetramethylammoniumhydroxid) gewählt ist.

9. Verfahren nach einem der Ansprüche 1 bis 8, bei dem der Lithografieschritt (E2, E30, E200) nach einer Technik durchgeführt wird, die unter einer optischen Technologie, einer elektronischen Technologie, einer Nanodrucktechnologie und einer Technologie der Selbstassemblierung von Blockcopolymeren gewählt ist.

10. Mikro-/nanofluidische Struktur, die eine Siliciumschicht umfasst, wobei die Struktur mindestens eine poröse Membran (10) in der Siliciumschicht (1) beinhaltet, die einen Mikro-/Nanofilter bildet, der mithilfe des in einem der vorhergehenden Ansprüche definierten Verfahrens ausgeführt wurde.

## Claims

1. Method for manufacturing a microfilter/nanofilter on a microchannel/nanochannel or microcavity/nanocavity that are present in a silicon layer, the method comprising the following steps:
- a lithography step (E2, E30, E200), to generate a resin layer (2, 20, 200) on said silicon layer (1) so as to form a resin structure on the silicon layer, said structure comprising at least one target zone (Z);
- a step of producing a carbon-based layer (4, 40, 400) on the surface of said silicon layer (1) in said target zone;
- a step of creating (E3, E40, E400) implanted zones by ion implantation through said structure formed by said resin layer (2, 20, 200) in said target zone;
- a step of removing (E4, E50, E600) the resin layer (2) and of maintaining, at least partly, the carbon-based layer (4, 40, 400) on said target zone;
- a step of porosifying (E5, E60, E700) the silicon and the carbon-based layer in said target zone in order to obtain a porosified target zone (5, 50, 500);
- a step of cleaning (E6, E70, E800) said porosified target zone in order to remove the porous silicon from said target zone and to form at least one cavity (6, 60, 600) that is closed on the surface by a carbon-based porous membrane (10).

2. Method according to Claim 1, in which said step of producing a carbon-based layer is carried out during the step of creating (E3) implanted zones by degradation of said resin layer (200), by an ion implantation of heavy ions.

3. Method according to Claim 1, in which said step of producing a carbon-based layer comprises a step of depositing (E20) a carbon-based layer (40) on the silicon layer (1), produced prior to said lithography step.

4. Method according to Claim 3, in which the carbon-based layer (40) is a layer of BARC (bottom anti-reflective coating) type.

5. Method according to Claim 3 or 4, in which said step of creating implanted zones is carried out by ion implantation using heavy ions.

6. Method according to Claim 2 or 5, in which the heavy ions used are ions of an atom having a density higher than that of boron.

7. Method according to Claim 1, in which the step of producing a carbon-based layer comprises a step of ion implantation (E300) of carbon ions through the structure formed by said resin layer (2) and in that this step is carried out between the lithography step (E200) and said step of creating implanted zones (E400).

8. Method according to one of Claims 1 to 7, in which the cleaning step (E6, E70, E800) is carried out in a solution for wet etching of the silicon, chosen from an etching based on KOH (potassium hydroxide) or an etching based on TMAH (trimethylammonium hydroxide).

9. Method according to one of Claims 1 to 8, in which the lithography step (E2, E30, E200) is carried out according to a technology chosen from an optical-type technology, an electronic-type technology, a nanoimprinting technology and a block copolymer self-assembly technology.

10. Microfluidic/nanofluidic structure comprising a silicon layer, the structure comprising at least one porous membrane (10) in the silicon layer (1) forming a microfilter/nanofilter produced using the method as defined in one of the preceding claims.
